# EUROPEAN PATENT APPLICATION

(11) **EP 4 318 571 A1**
(43) Date of publication of application: **07.02.2024**
(21) Application number: 22784342.2
(22) Date of filing: 15.02.2022
(51) Int. Cl.: H01L 23/34, H01L 25/07, H01L 25/18, H02M 7/48

(54) **SEMICONDUCTOR DEVICE**

(30) Priority: 06.04.2021 JP 2021064731
(71) Applicant: Mitsubishi Heavy Industries, Ltd., Tokyo 100-8332 (JP)
(72) Inventor: EZUMI, Masahiko, Tokyo 100-8332 (JP)
(74) Representative: Studio Torta S.p.A.
(86) International application number: PCT/JP2022/005911
(87) International publication number: WO 2022/215357

(57) **Abstract**

There is provided a semiconductor device including: a substrate body configured to include a first surface and a second surface opposite to the first surface; a power semiconductor element configured to be mounted on the first surface; a cooler configured to be in contact with the second surface; and a temperature sensor configured to measure the temperature of the power semiconductor element, in which the temperature sensor is provided on a first side which is a side on which the power semiconductor element is mounted with respect to the substrate body, and is provided at a position farther away from the first surface of the substrate body than the power semiconductor element.

## Description

### [Technical Field]

The present disclosure relates to a semiconductor device.

Priority is claimed on Japanese Patent Application No. 2021-064731, filed April 6, 2021, the content of which is incorporated herein by reference.

### [Background Art]

Patent Document 1 discloses a power semiconductor element used in a power converter such as an inverter. The power semiconductor element functions as a portion of a circuit that performs conversion of electric power or boosting-up and boosting-down of a voltage, and handles a large current. As a result, the power semiconductor element generates a large amount of heat. For this reason, a control device of a power converter needs to monitor the temperature of the power semiconductor element using a temperature sensor while cooling the power semiconductor element with a cooler.

For example, the temperature sensor may be mounted on the same substrate as a substrate on which the power semiconductor element is mounted to be separated from the power semiconductor element in an in-plane direction. The temperature sensor measures the temperature of heat conducted from the power semiconductor element at a mounting place. The control device can indirectly monitor the temperature of the power semiconductor element based on a measurement result of the temperature sensor.

### [Citation List]

### [Patent Document]

[Patent Document 1]
Japanese Unexamined Patent Application, First Publication No. 2015-122876

### [Summary of Invention]

### [Technical Problem]

Meanwhile, in recent years, it is desired to improve cooling performance of a cooler for cooling the power semiconductor element such that the power semiconductor element can handle a larger current. As the cooling performance of the cooler of the power semiconductor element is improved, the heat of the power semiconductor element is less likely to be dissipated in the in-plane direction. In this way, in a case where the heat of the power semiconductor element is less likely to be dissipated in the in-plane direction, an amount of heat conducted to a place where the temperature sensor is mounted decreases. As a result, there is a possibility that measurement accuracy of the temperature sensor with respect to a temperature rise of the power semiconductor element deteriorates.

The present disclosure has been made to solve the above problems, and an object of the present disclosure is to provide a semiconductor device capable of preventing deterioration in measurement accuracy of the temperature sensor.

### [Solution to Problem]

In order to solve the above problems, according to the present disclosure, there is provided a semiconductor device including: a substrate body configured to include a first surface and a second surface opposite to the first surface; a power semiconductor element configured to be mounted on the first surface; a cooler configured to be in contact with the second surface; and a temperature sensor configured to measure the temperature of the power semiconductor element, in which the temperature sensor is provided on a first side which is a side on which the power semiconductor element is mounted with respect to the substrate body, and is provided at a position farther away from the first surface of the substrate body than the power semiconductor element.

### [Advantageous Effects of Invention]

According to the present disclosure, it is possible to provide a semiconductor device capable of preventing deterioration in measurement accuracy of the temperature sensor.

### [Brief Description of Drawings]

FIG. 1 is a view of a semiconductor device according to a first embodiment of the present disclosure when viewed from a side.
FIG. 2 is a view of a semiconductor device according to a second embodiment of the present disclosure when viewed from a side.
FIG. 3 is a view of the semiconductor device according to the second embodiment of the present disclosure when viewed from a lamination direction.
FIG. 4 is a view of a modification example of the semiconductor device according to the second embodiment of the present disclosure when viewed from a lamination direction.

### [Description of Embodiments]

### [First Embodiment]

### (Semiconductor Device)

Hereinafter, a semiconductor device according to a first embodiment of the present disclosure will be described with reference to the drawings. The semiconductor device according to the present embodiment forms, for example, a portion of a power conversion circuit included in a power converter such as an inverter or a converter.

The semiconductor device according to the present embodiment is used for an inverter that receives a DC current as an input and outputs an AC current.

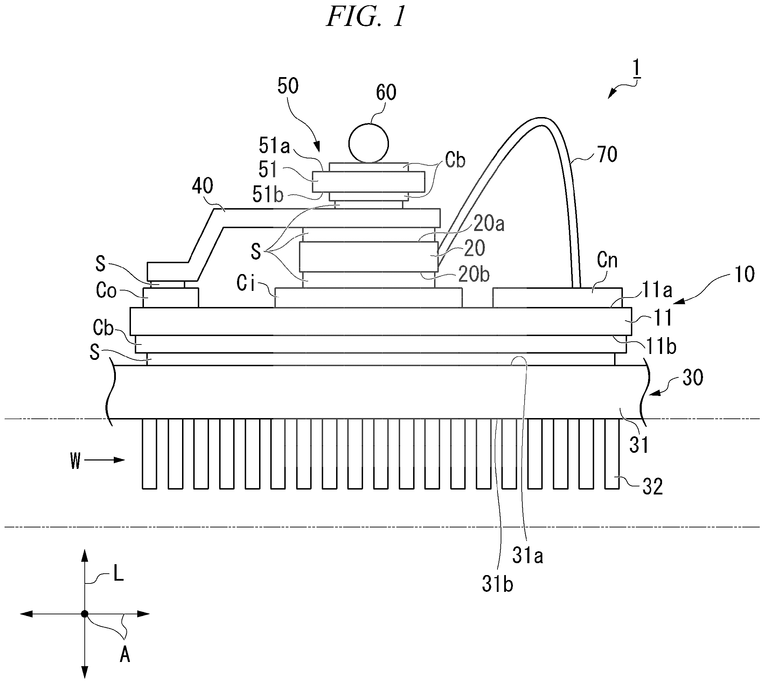

FIG. 1 is a view of a semiconductor device according to the first embodiment when viewed from a side. As shown in FIG. 1, a semiconductor device 1 according to the present embodiment includes a substrate 10, a power semiconductor element 20, a cooler 30, a lead frame 40, an insulating substrate 50, and a temperature sensor 60.

### (Substrate)

The substrate 10 includes a substrate body 11, an input circuit Ci, an output circuit Co, a control circuit Cn, and a bonding pattern Cb.

The substrate body 11 is a member having a flat plate shape. The substrate body 11 has a first surface 11a and a second surface 11b located on a back side of the first surface 11a. That is, the first surface 11a and the second surface 11b of the substrate body 11 are opposite to each other.

Hereinafter, in the present embodiment, a direction in which the substrate body 11 extends (a paper surface depth direction and a vertical direction in FIG. 1) will be referred to as an in-plane direction A.

In the present embodiment, for example, ceramic is used for the substrate body 11.

Note that, for the substrate body 11, paper phenol, paper epoxy, glass composite, glass epoxy, glass polyimide, fluororesin, or the like may be used.

The input circuit Ci, the output circuit Co, and the control circuit Cn are patterns of copper foil or the like, which are formed on the first surface 11a of the substrate body 11 to be separated from each other in the in-plane direction A. More specifically, these circuits are integrally formed with the substrate body 11 by being brazed on the first surface 11a of the substrate body 11, and each of the circuits forms an independent circuit pattern on the substrate body 11.

A DC current, which is an input to the semiconductor device 1, is input to the input circuit Ci from the outside of the substrate 10 via an input bus bar (not shown) extending from a portion of the substrate body 11.

The output circuit Co is formed to be separated from the input circuit Ci in the in-plane direction A. The output circuit Co outputs an AC current converted by the semiconductor device 1 to a device provided outside the substrate 10 via an output bus bar (not shown) extending from a portion of the substrate body 11.

A detailed configuration of the control circuit Cn in the present embodiment will be described later.

The bonding pattern Cb is a pattern such as copper foil provided on the second surface 11b of the substrate body 11. The bonding pattern Cb is integrally formed with the substrate body 11 by being brazed on the entire second surface 11b in order to bond the cooler 30 to be described later.

The input circuit Ci, the output circuit Co, and the control circuit Cn, which are formed on the first surface 11a, and the bonding pattern Cb formed on the second surface 11b are electrically insulated by the substrate body 11 that is made of an electrically insulating material and is interposed therebetween.

### (Power Semiconductor Element)

The power semiconductor element 20 is, for example, an IGBT, a MOSFET, an FWD, or the like, and has an input surface 20b and an output surface 20a located on a back side of the input surface 20b. The input surface 20b is provided with an input terminal (not shown) to which a current is input, and the output surface 20a is provided with an output terminal (not shown) from which a converted current is output. The input terminal is electrically connected to the input circuit Ci formed on the first surface 11a of the substrate body 11 via a bonding material S. That is, the power semiconductor element 20 is mounted on the first surface 11a of the substrate body 11. Hereinafter, a direction in which the substrate 10 and the power semiconductor element 20 are laminated (in FIG. 1, a horizontal direction) will be referred to as a lamination direction L.

The power semiconductor element 20 includes at least a power transistor circuit (not shown) in which a power transistor is incorporated as a circuit element.

The power semiconductor element 20 receives a control signal which is input from the control circuit Cn to be described later via a control wire 70. The power semiconductor element 20 performs switching according to the control signal which is input from the control circuit Cn.

### (Cooler)

The cooler 30 is bonded to the bonding pattern Cb provided on the second surface 11b of the substrate 10 via a bonding material S. The cooler 30 includes a base portion 31 and heat dissipation fins 32. The base portion 31 has a bonding surface 31a that is bonded to the bonding pattern Cb of the substrate 10 via the bonding material S and a fin surface 31b that is opposite to the bonding surface 31a and on which the heat dissipation fins 32 are provided. A plurality of heat dissipation fins 32 are provided to extend from the fin surface 31b of the base portion 31 in the lamination direction L.

Thereby, in a case where the power semiconductor element 20 generates heat, the heat of the power semiconductor element 20 is conducted to the bonding material S connecting the power semiconductor element 20 and the input circuit Ci, the input circuit Ci, the substrate body 11, the bonding pattern Cb, the bonding material S connecting the substrate body 11 and the base portion 31, the base portion 31, and the heat dissipation fins 32 in this order. Therefore, the heat dissipated from the input surface 20b of the power semiconductor element 20 in the lamination direction L propagates along the path, and is dissipated by the heat dissipation fins 32.

In the present embodiment, for example, aluminum is used as a material of the base portion 31 and the heat dissipation fins 32 of the cooler 30. Note that iron, copper, ceramic, or the like may be used for the base portion 31 and the heat dissipation fins 32 of the cooler 30.

The heat dissipation fins 32 of the cooler 30 are immersed in a refrigerant flow path (details are not shown) through which a refrigerant flows. In FIG. 1, a schematic shape of the refrigerant flow path is shown by a two-dotted chain line, and a flow W of the refrigerant is shown by a rightward arrow. The heat dissipation fins 32 constantly exchange heat with the refrigerant flowing through the refrigerant flow path, and the heat conducted from the power semiconductor element 20 is dissipated by a water cooling method. In the present embodiment, for example, water is used as the refrigerant. Note that a liquid other than water may be used as the refrigerant.

### (Lead Frame)

The lead frame 40 is a conductor that electrically connects the power semiconductor element 20 and the output circuit Co by bridging the power semiconductor element 20 and the output circuit Co. The lead frame 40 has one end connected to the output circuit Co and the other end connected to the power semiconductor element 20. More specifically, the one end of the lead frame 40 is connected to the output circuit Co formed on the first surface 11a of the substrate body 11 via the bonding material S. The other end of the lead frame 40 is connected to the output terminal provided on the output surface 20a via the bonding material S to cover at least a portion of the output surface 20a of the power semiconductor element 20. In the present embodiment, for example, a copper clip is used for the lead frame 40.

### (Insulating Substrate)

The insulating substrate 50 is an insulating member in contact with the lead frame 40 via the bonding material S. The insulating substrate 50 includes an insulating substrate body 51 and bonding patterns Cb.

The insulating substrate body 51 is a member having a flat plate shape. The insulating substrate body 51 has an insulating surface 51b and a sensor mounting surface 51a located on a back side of the insulating surface 51b. That is, the insulating surface 51b and the sensor mounting surface 51a of the insulating substrate body 51 are opposite to each other.

In the present embodiment, for example, ceramic is used for the insulating substrate body 51. Note that, for the insulating substrate body 51, paper phenol, paper epoxy, glass composite, glass epoxy, glass polyimide, fluororesin, or the like may be used.

The bonding patterns Cb in the present embodiment are patterns that are made of copper foil or the like and are provided on the insulating surface 51b and the sensor mounting surface 51a of the insulating substrate 50. More specifically, the bonding patterns Cb are integrally formed with the insulating substrate body 51 by being brazed on each of the insulating surface 51b and the sensor mounting surface 51a of the insulating substrate body 51. The bonding pattern Cb formed on the insulating surface 51b and the bonding pattern Cb formed on the sensor mounting surface 51a are electrically insulated by the insulating substrate body 51 that is interposed therebetween.

The bonding pattern Cb formed on the insulating surface 51b is connected to the lead frame 40 via the bonding material S. A sensor lead wire (not shown) is connected to the bonding pattern Cb formed on the sensor mounting surface 51a. One end of the sensor lead wire is connected to a control device (not shown) of a power converter provided outside the semiconductor device 1, and the other end of the sensor lead wire is connected to the bonding pattern Cb. The sensor lead wire supplies a current for operating the temperature sensor 60 mounted on the sensor mounting surface 51a from the control device, and outputs a response signal as a measurement result output by the temperature sensor 60 to the control device.

For the bonding material S for connecting the power semiconductor element 20 and the input circuit Ci of the substrate 10, connecting the base portion 31 of the cooler 30 and the bonding pattern Cb of the substrate 10, connecting the lead frame 40 and the output circuit Co, connecting the lead frame 40 and the power semiconductor element 20, and connecting the lead frame 40 and the bonding pattern Cb of the insulating substrate 50, for example, a solder or the like is used. Note that a sintered material (a powder of metal, ceramic, or the like) may be used as the bonding material S. Further, for the bonding material S for connecting the base portion 31 of the cooler 30 and the bonding pattern Cb of the substrate 10 and connecting the lead frame 40 and the bonding pattern Cb of the insulating substrate 50, an adhesive may be used.

### (Temperature Sensor)

The temperature sensor 60 is mounted on the bonding pattern Cb formed on the sensor mounting surface 51a of the insulating substrate 50. The temperature sensor 60 is a sensor that measures the temperature at a place where the bonding pattern Cb is mounted on the insulating substrate 50. In the present embodiment, for the temperature sensor 60, for example, a thermistor is used. Note that a temperature resistor or the like may be used for the temperature sensor 60.

The temperature sensor 60 is provided on a first side, which is a side on which the power semiconductor element 20 is mounted with respect to the substrate 10, and is provided at a position farther away from the first surface 11a of the substrate body 11 than the power semiconductor element 20. Further, the temperature sensor 60 in the present embodiment is located in a region where the lead frame 40 overlaps the power semiconductor element 20 in the lamination direction L.

The heat dissipated from the power semiconductor element 20 is conducted through the bonding material S for connecting the power semiconductor element 20 and the lead frame 40, the lead frame 40, the bonding material S for connecting the lead frame 40 and the bonding pattern Cb, the bonding pattern Cb, the insulating substrate 50, the bonding pattern Cb, and the temperature sensor 60 in this order in the lamination direction L. A mounting place of the temperature sensor 60 on the sensor mounting surface 51a is warmed by the heat conducted through the path. In the present embodiment, it is desirable that the temperature sensor 60 is provided at a substantially center position of the power semiconductor element 20 when viewed from the lamination direction L.

### (Control Circuit)

The control circuit Cn is provided on the first surface 11a of the substrate body 11 to be separated from the input circuit Ci in the in-plane direction A. A control wire 70 is connected to the control circuit Cn such that an electric signal for controlling the power semiconductor element 20 can be transmitted from the control circuit Cn. One end of the control wire 70 is electrically connected to the control circuit Cn, and the other end of the control wire 70 is electrically connected to an input terminal (not shown) of the control signal of the power semiconductor element 20.

A control unit (not shown) that generates the control signal of the power semiconductor element 20 is connected to the control circuit Cn. Thereby, the control circuit Cn can input the control signal generated by the control unit to the power semiconductor element 20 via the control wire 70. In the present embodiment, for example, aluminum is used for the control wire 70. Note that copper, gold, or the like may be used for the control wire 70.

### (Operational Effects)

The semiconductor device 1 according to the first embodiment includes the substrate body 11 having the first surface 11a and the second surface 11b opposite to the first surface 11a, the power semiconductor element 20 mounted on the first surface 11a, the cooler 30 in contact with the second surface 11b, and the temperature sensor 60 that measures the temperature of the power semiconductor element 20. The temperature sensor 60 is provided on the first side, which is a side on which the power semiconductor element 20 is mounted with respect to the substrate body 11, and is provided at a position farther away from the first surface 11a of the substrate body 11 than the power semiconductor element 20.

According to such a configuration, the heat conducted to the temperature sensor 60 from the power semiconductor element 20 is not affected by the heat dissipation in the in-plane direction A of the substrate 10 on which the power semiconductor element 20 is mounted. Therefore, for example, even in a case where performance of the cooler 30 is improved and thus the heat dissipation in the in-plane direction A of the substrate 10 is reduced, it is possible to prevent deterioration in measurement accuracy of the temperature sensor 60.

In addition, the semiconductor device 1 according to the first embodiment further includes the lead frame 40 connected to the power semiconductor element 20 and the insulating substrate 50 that is connected to the lead frame 40 and the temperature sensor 60 to conduct heat and electrically insulates the lead frame 40 and the temperature sensor 60.

According to such a configuration, the temperature sensor 60 does not affect circuits related to the input and the output of the power semiconductor element 20. Therefore, a degree of freedom in circuit design of the power semiconductor element 20 is not lowered.

Further, in the lamination direction L in which the substrate 10 and the power semiconductor element 20 are laminated, the temperature sensor 60 is located in a region where the lead frame 40 overlaps the power semiconductor element 20.

According to such a configuration, the temperature sensor 60 is located at a place where the heat generated in the power semiconductor element 20 is conducted without loss. Therefore, the temperature of a place that is measured by the temperature sensor 60 can be made close to an actual temperature of the power semiconductor element 20.

In addition, in the semiconductor device 1 according to the first embodiment, the cooler 30 includes the base portion 31 in contact with the second surface 11b of the substrate 10 and the heat dissipation fins 32 that extend from the base portion 31 toward the other side in the lamination direction L.

According to such a configuration, the cooler 30 does not cool a place that is measured by the temperature sensor 60. Therefore, it is possible to cool the power semiconductor element 20 without affecting a measurement value of the temperature sensor 60.

### [Second Embodiment]

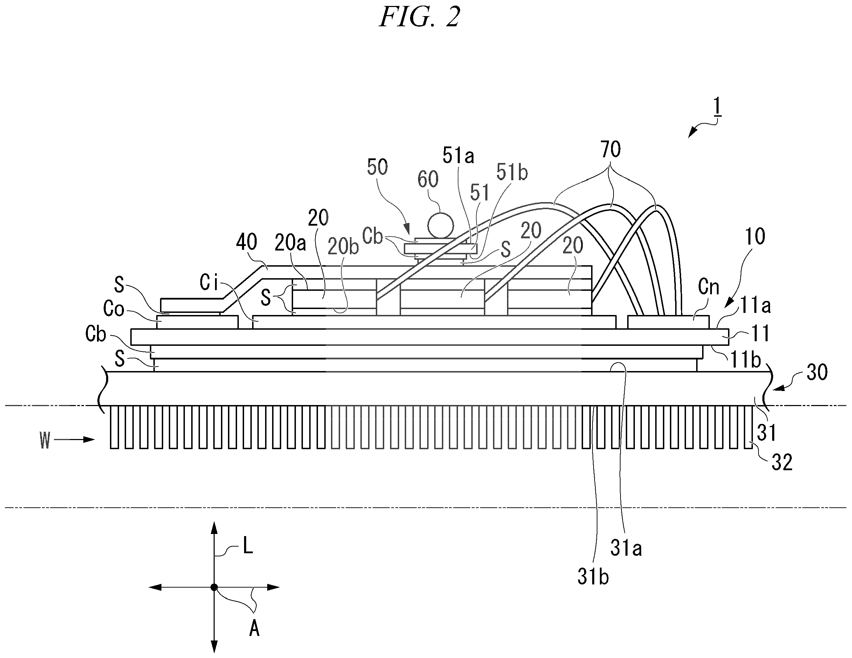

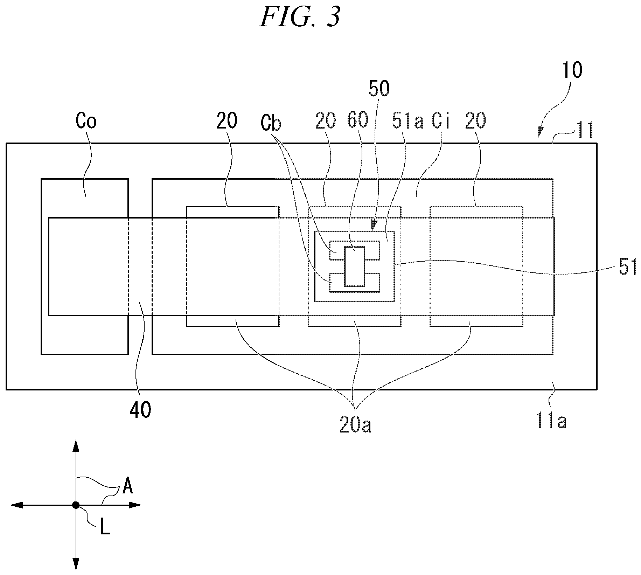

Hereinafter, a semiconductor device according to a second embodiment of the present disclosure will be described with reference to FIG. 2 and FIG. 3. In the second embodiment, the configurations of the power semiconductor element 20, the lead frame 40, and the control circuit Cn included in the semiconductor device 1 according to the first embodiment are partially different. Components similar to those in the first embodiment are denoted by the same reference numerals, and a detailed description thereof will be omitted.

FIG. 2 is a view of a semiconductor device according to the second embodiment when viewed from a side. As shown in FIG. 2, a semiconductor device 1 according to the present embodiment includes a plurality of power semiconductor elements 20.

### (Power Semiconductor Element)

Each of the plurality of power semiconductor elements 20 has an input surface 20b and an output surface 20a located on a back side of the input surface 20b. In the plurality of power semiconductor elements 20, each of input terminals (not shown) provided on the input surface 20b is electrically connected to the input circuit Ci provided on the first surface 11a of the substrate body 11 via the bonding material S. That is, the plurality of power semiconductor elements 20 are mounted on the first surface 11a of the substrate body 11.

In the present embodiment, three power semiconductor elements 20 are mounted in parallel on the first surface 11a of the substrate body 11. Among the three power semiconductor elements 20 mounted in parallel on the first surface 11a of the substrate body 11, the center power semiconductor element 20 interposed between two power semiconductor elements 20 is affected by the heat dissipated from the two power semiconductor elements 20. As a result, the temperature of the center power semiconductor element 20 tends to be relatively high.

### (Cooler)

The cooler 30 is bonded to the bonding pattern Cb provided on the second surface 11b of the substrate 10 via the bonding material S. The cooler 30 has the same configuration as the configuration of the first embodiment.

FIG. 3 is a view of the semiconductor device 1 when viewed from the lamination direction L. In the semiconductor device 1 shown in FIG. 3, showing of the control circuit Cn is omitted.

### (Lead frame)

The lead frame 40 is a conductor that electrically connects the plurality of power semiconductor elements 20 and the output circuit Co by bridging the plurality of power semiconductor elements 20 and the output circuit Co. As shown in FIG. 3, a portion of the lead frame 40 is connected to the output circuit Co, and a plurality of portions of the remaining portion are connected to the plurality of power semiconductor elements 20. More specifically, the remaining portion of the lead frame 40 linearly extends to cover at least a portion of each of the output surfaces 20a of the plurality of power semiconductor elements 20, and is connected to an output terminal provided on each of the output surfaces 20a.

### (Insulating Substrate)

The insulating substrate 50 is an insulating member in contact with the lead frame 40. The insulating substrate 50 has the same configuration as the configuration of the first embodiment.

### (Temperature Sensor)

The temperature sensor 60 is mounted on the bonding pattern Cb formed on the sensor mounting surface 51a of the insulating substrate 50. The temperature sensor 60 is a sensor that measures the temperature at a place where the bonding pattern Cb is mounted on the insulating substrate 50. The temperature sensor 60 is located in a region where the lead frame 40 overlaps the power semiconductor element 20 in the lamination direction L. In the present embodiment, the temperature sensor 60 is located at a substantially center position of a region where the center power semiconductor element 20 and the lead frame 40 overlap each other in the lamination direction L among the three power semiconductor elements 20 mounted in parallel on the substrate 10.

### (Control Circuit)

A plurality (three in the present embodiment) of control wires 70 are connected to the control circuit Cn such that electric signals for controlling the power semiconductor elements 20 can be transmitted from the control circuit Cn. One end of each of the plurality of control wires 70 is electrically connected to the control circuit Cn, and the other end of each of the plurality of control wires 70 is electrically connected to an input terminal (not shown) of the control signal of each of the power semiconductor elements 20.

### (Operational Effects)

In the semiconductor device 1 according to the second embodiment, the plurality of power semiconductor elements 20 are mounted on the first surface 11a of the substrate body 11, and the lead frame 40 extends over the plurality of power semiconductor elements 20 and is connected to the plurality of power semiconductor elements 20.

According to such a configuration, the temperature sensor 60 can collectively measure the temperatures of the plurality of power semiconductor elements 20. Therefore, for example, even in a case where an abnormality in which the temperature of any of the power semiconductor elements 20 excessively rises occurs, it is possible to realize overtemperature protection of the power semiconductor element 20 based on the measurement value of the temperature sensor 60.

Further, in the semiconductor device 1 according to the second embodiment, the temperature sensor 60 is located at a substantially center position of a region where the center power semiconductor element 20 and the lead frame 40 overlap each other in the lamination direction L among the three power semiconductor elements 20 mounted in parallel on the substrate 10.

According to such a configuration, the temperature sensor 60 can measure the temperature of a place where the temperature is relatively high. Therefore, it is possible to more appropriately realize overtemperature protection of the power semiconductor element 20 based on the measurement value of the temperature sensor 60.

### [Another Embodiment]

As described above, the embodiments of the present disclosure have been described in detail with reference to the drawings. On the other hand, the specific configuration is not limited to the configurations in the embodiments, and addition, omission, substitution, and other modification can be made without departing from the scope of the present disclosure. In addition, the present disclosure is not limited by the embodiments.

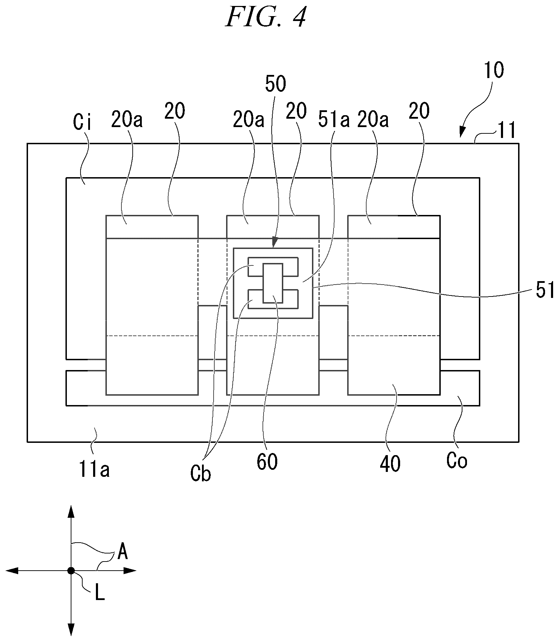

In the second embodiment, the lead frame 40 linearly extends to cover at least a portion of each of the output surfaces 20a of the plurality of power semiconductor elements 20, and is connected to each of the output surfaces 20a. On the other hand, the present disclosure is not limited to the configuration. FIG. 4 shows a modification example of the lead frame 40 according to the second embodiment. As shown in FIG. 4, the lead frames 40 may be configured to extend from any three places on the output circuit Co toward the output surface 20a of each of the power semiconductor elements 20, to extend to cover at least a portion of each of the output surfaces 20a of the plurality of power semiconductor elements 20, and to be connected to each other. Thereby, the same operational effects as those of the second embodiment can be achieved.

Further, in the embodiments, a case where one power semiconductor element 20 is mounted on the substrate 10 and a case where three power semiconductor elements 20 are mounted in parallel on the substrate 10 have been described. On the other hand, the number of the power semiconductor elements 20 to be mounted is not limited to the number. Two or four or more power semiconductor elements 20 may be mounted.

For example, in a case where two power semiconductor elements 20 are mounted in parallel, the temperature sensor 60 may not necessarily be located in a region where the lead frame 40 overlaps the power semiconductor element 20 in the lamination direction L. The temperature sensor 60 may be configured to measure the temperature of a mounting place at a substantially middle position between the two power semiconductor elements 20. Thereby, the temperatures of the two power semiconductor elements 20 can be efficiently measured, and the same operational effects as those of the second embodiment can be obtained.

In addition, in the embodiments, the temperature sensor 60 is located in the region where the lead frame 40 overlaps the power semiconductor element 20 in the lamination direction L. On the other hand, the present disclosure is not limited to the configuration. A configuration may be adopted in which at least a portion of the temperature sensor 60 is located in a region where the lead frame 40 overlaps the power semiconductor element 20 in the lamination direction L. Even in this case, the operational effects described in the embodiments can be achieved.

Further, in the embodiments, a copper clip is used for the lead frame 40. On the other hand, the present disclosure is not limited to the copper clip. Any conductor may be used for the lead frame 40 as long as at least the insulating substrate 50 can be made in contact with the lead frame 40 and the temperature sensor 60 can stably measure the temperature of the power semiconductor element 20 on the insulating substrate 50.

Further, in the embodiments, the insulating substrate 50 having a flat plate shape is used. On the other hand, the present disclosure is not limited to the flat plate shape. An insulating member having any shape may be used as long as at least the lead frame 40 and the temperature sensor 60 are connected to conduct heat, the lead frame 40 and the temperature sensor 60 are electrically insulated, and the temperature sensor 60 can stably measure the temperature of the power semiconductor element 20.

Further, in the embodiments, the semiconductor device 1 is used for a power conversion circuit of an inverter. On the other hand, the present disclosure is not limited to a power conversion circuit of an inverter. The semiconductor device 1 may form a portion of a power conversion circuit of a converter that receives an AC current as an input and outputs a DC current, a portion of a boost circuit of a regulator that changes a magnitude of a voltage of the DC current, or the like.

### [Appendix]

The semiconductor device described in the embodiments is understood, for example, as follows.

(1) According to a first aspect, there is provided a semiconductor device 1 including: a substrate body 11 configured to include a first surface 11a and a second surface 11b opposite to the first surface 11a; a power semiconductor element 20 configured to be mounted on the first surface 11a; a cooler 30 configured to be in contact with the second surface 11b; and a temperature sensor 60 configured to measure the temperature of the power semiconductor element 20, in which the temperature sensor 60 is provided on a first side which is a side on which the power semiconductor element 20 is mounted with respect to the substrate body 11, and is provided at a position farther away from the first surface 11a of the substrate body 11 than the power semiconductor element 20.
   Thereby, the heat conducted to the temperature sensor 60 from the power semiconductor element 20 is not affected by the heat dissipation in the in-plane direction A of the substrate 10 on which the power semiconductor element 20 is mounted. Therefore, for example, even in a case where performance of the cooler 30 is improved and thus the heat dissipation in the in-plane direction A of the substrate 10 is reduced, it is possible to prevent deterioration in measurement accuracy of the temperature sensor 60.
(2) According to a second aspect, the semiconductor device 1 according to (1) may further include: a lead frame 40 configured to be connected to the power semiconductor element 20; and an insulating member configured to be connected to the lead frame 40 and the temperature sensor 60 to conduct heat and to electrically insulate the lead frame 40 and the temperature sensor 60.
   Thereby, the temperature sensor 60 does not affect circuits related to the input and the output of the power semiconductor element 20. Therefore, a degree of freedom in circuit design of the power semiconductor element 20 is not lowered.
(3) According to a third aspect, in the semiconductor device 1 according to (2), a plurality of the power semiconductor elements 20 may be mounted on the first surface 11a of the substrate body 11, and the lead frame 40 may extend over the plurality of the power semiconductor elements 20 and may be connected to the plurality of the power semiconductor elements 20.
   Thereby, the temperature sensor 60 can collectively measure the temperatures of the plurality of power semiconductor elements 20. Therefore, for example, even in a case where an abnormality in which the temperature of any of the power semiconductor elements 20 excessively rises occurs, it is possible to realize overtemperature protection of the power semiconductor element 20 based on the measurement value of the temperature sensor 60.
(4) According to a fourth aspect, in the semiconductor device 1 according to (2) or (3), at least a portion of the temperature sensor 60 may be located in a region where the lead frame 40 overlaps the power semiconductor element 20 in a lamination direction L in which the substrate body 11 and the power semiconductor element 20 are laminated.
   Thereby, the temperature sensor 60 is located at a place where the heat generated in the power semiconductor element 20 is conducted without loss. Therefore, the temperature of a place that is measured by the temperature sensor 60 can be made close to the actual temperature of the power semiconductor element 20.
(5) According to a fifth aspect, in the semiconductor device 1 according to any one of (1) to (4), the cooler 30 may include a base portion 31 configured to be in contact with the second surface 11b of the substrate body 11, and heat dissipation fins 32 configured to extend from the base portion 31.

Thereby, the cooler 30 does not cool a place that is measured by the temperature sensor 60. Therefore, it is possible to cool the power semiconductor element 20 without affecting a measurement value of the temperature sensor 60.

### [Industrial Applicability]

According to the present disclosure, it is possible to provide a semiconductor device capable of preventing deterioration in measurement accuracy of the temperature sensor.

### [Reference Signs List]

1: Semiconductor device
10: Substrate
11: Substrate body
11a: First surface
11b: Second surface
20: Power semiconductor element
20a: Output surface
20b: Input surface
30: Cooler
31: Base portion
31a: Bonding surface
31b: Fin surface
32: Heat dissipation fin
40: Lead frame
50: Insulating substrate
51: insulating substrate body
51a: Sensor mounting surface
51b: Insulating surface
60: Temperature sensor
70: Control wire
A: In-plane direction
Cb: Bonding pattern
Ci: Input circuit
Cn: Control circuit
Co: Output circuit
L: lamination direction
S: bonding material
W: Flow of refrigerant

## Claims

1. A semiconductor device comprising:
a substrate body configured to include a first surface and a second surface opposite to the first surface;
a power semiconductor element configured to be mounted on the first surface;
a cooler configured to be in contact with the second surface; and
a temperature sensor configured to measure a temperature of the power semiconductor element, wherein
the temperature sensor is provided on a first side which is a side on which the power semiconductor element is mounted with respect to the substrate body, and is provided at a position farther away from the first surface of the substrate body than the power semiconductor element.

2. The semiconductor device according to Claim 1, further comprising:
a lead frame configured to be connected to the power semiconductor element; and
an insulating member configured to be connected to the lead frame and the temperature sensor to conduct heat and to electrically insulate the lead frame and the temperature sensor.

3. The semiconductor device according to Claim 2, wherein
a plurality of the power semiconductor elements are mounted on the first surface of the substrate body, and
the lead frame extends over the plurality of the power semiconductor elements and is connected to the plurality of the power semiconductor elements.

4. The semiconductor device according to Claim 2 or 3, wherein
at least a portion of the temperature sensor is located in a region where the lead frame overlaps the power semiconductor element in a lamination direction in which the substrate body and the power semiconductor element are laminated.

5. The semiconductor device according to any one of Claims 1 to 4, wherein
the cooler includes a base portion configured to be in contact with the second surface of the substrate body, and heat dissipation fins configured to extend from the base portion.
